# EUROPEAN PATENT APPLICATION

(11) **EP 2 482 352 A2**
(43) Date of publication of application: **01.08.2012**
(21) Application number: 12250018.4
(22) Date of filing: 01.02.2012
(51) Int. Cl.: H01L 35/30, B64C 1/40

(54) **Sinkless thermoelectric energy generator**

(30) Priority: 01.02.2011 US 931441
(71) Applicant: Simmonds Precision Products, Inc., Vergennes, VT 05491 (US)
(72) Inventor: Kline, Bruce R., Starksboro Vermont 05487 (US)
(74) Representative: Hargreaves, Timothy Edward

(57) **Abstract**

Disclosed is a sinkless electric generator for generating electrical power from temperature cycles encountered by the structure of an aircraft. The sinkless electric generator includes a thermoelectric generator which is in thermal contact with the structure of the aircraft (e.g., the aircraft's skin); an insulated housing containing a thermal mass; and a circuit for providing the energy generated by the thermoelectric generator during the temperature cycles encountered by the structure of the aircraft to a device. The insulated housing is positioned in thermal contact with the thermoelectric generator; wherein during the temperature cycles encountered by the structure of the aircraft, energy is created by the thermoelectric generator when heat is released from the thermal mass contained within the housing through the thermoelectric generator to the aircraft's structure and when heat is supplied from the aircraft's structure through the thermoelectric generator to the thermal mass.

## Description

### BACKGROUND OF THE INVENTION

### 1. Field of the Invention

The subject invention is directed to thermoelectric energy harvesting devices and methods of making the same, and more particularly to thermoelectric energy generators that do not require a conventional heat sink (i.e., "sinkless").

### 2. Background of the Invention

Energy harvesting devices generate electrical power from energy sources that are often overlooked and untapped. Examples of energy sources and methods to convert electricity include photovoltaic devices which convert light energy into electricity, piezoelectric beams which convert vibrational energy into electricity and thermoelectric devices which convert heat flow into electricity. These energy harvesting devices and methods are amenable to a variety of applications.

For example, as low power electronics become increasingly prevalent, energy harvesting devices and methods provide a useful way to power electronic devices without the need for batteries or electrical power wiring. Electrical wiring is undesirable in many applications due to its cost to design and install, as well as its weight and difficulty to retrofit. Batteries are undesirable on aircraft due to the difficulty of replacement and because some batteries pose environmental or safety hazards. Additionally, batteries typically function poorly in low temperatures. In some cases, electronic devices that occasionally require medium quantities of electrical power for short periods of time may be powered using low-power energy harvesting devices. In these cases, electrical energy generated by energy harvesting devices is stored in a capacitor or rechargeable battery.

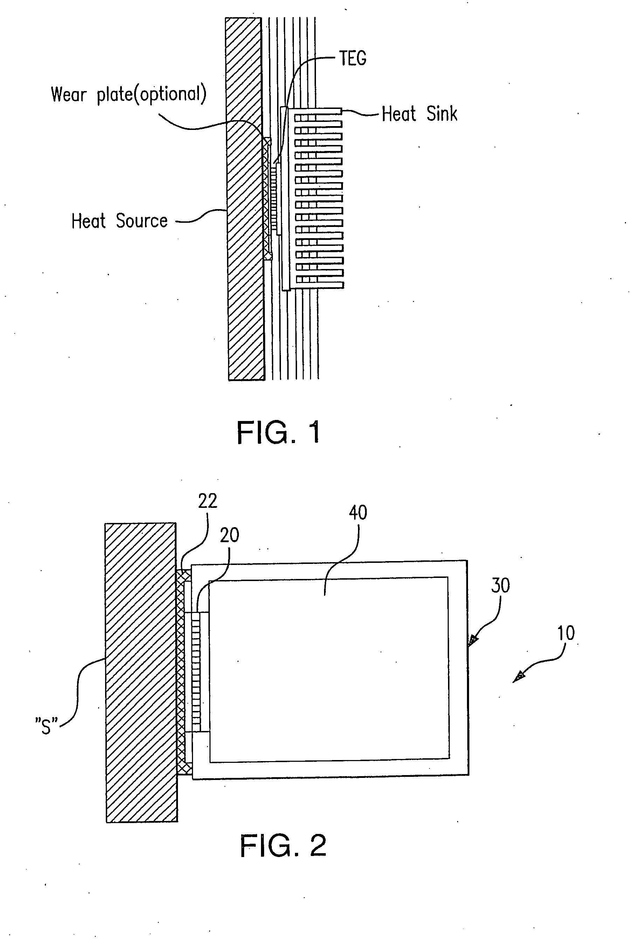

Although, thermoelectric generators (TEGs) hold the promise of supplying relatively large amounts of power (much greater than other ambient sources), they traditionally require both a source of heat and a cooler heat sink that are physically close to each other. For example, Figure 1 provides an illustration of a conventional TEG being mounted on the interior of an aircraft skin. As shown in this figure, conventional TEGs require large, finned heat sinks or complicated (i.e. heavy) plumbing which have made TEGs unsuitable for many applications, including aircraft.

Therefore, there is a need for a thermoelectric generator which does not require the use of a large, finned heat sink, and more particularly there is a need for a thermoelectric generator which is compact, lightweight and is especially adapted for use in aircraft and is capable of creating energy from temperature cycles which are experienced onboard the aircraft.

### SUMMARY OF THE INVENTION

The present invention is directed to an electric generator for generating electrical power from temperature cycles encountered by the structure of an aircraft. The electric generator includes, *inter alia,* a thermoelectric generator which is in thermal contact with the structure of the aircraft; an insulated housing containing a thermal mass; and a circuit for providing the energy generated by the thermoelectric generator during the temperature cycles encountered by the structure of the aircraft to a device, such as a wireless sensor.

The insulated housing is positioned in thermal contact with the thermoelectric generator. During the temperature cycles encountered by the structure of the aircraft, electrical energy is created by the thermoelectric generator when heat is released from the thermal mass through the thermoelectric generator to the aircraft's structure and when heat is supplied from the aircraft's structure through the thermoelectric generator to the thermal mass.

In an embodiment of the present invention, the thermoelectric generator is in thermal contact with the skin of the aircraft and the skin of the aircraft encounters temperature cycles during ascent and descent. Alternatively, the thermoelectric generator can be in thermal contact with the airframe of the aircraft and the airframe of the aircraft encounters temperature cycles during ascent and descent. Still further, the thermoelectric generator can be in thermal contact with the structure of the aircraft that encounters temperature cycles during operation of the aircraft's engine, for example.

Preferably, the thermal mass includes water. It is envisioned that the thermal mass can include both water and propylene glycol. In certain constructions it is preferred that the thermal mass is fifty percent water and fifty percent propylene glycol and has a specific heat of about 3.33J/g°K.

The energy generated by the thermoelectric generator of the present invention can be used to power a wireless sensor, for example.

In certain embodiments of the present invention, a wear plate is positioned between the thermoelectric generator and the structure of the aircraft. The wear plate can be used to protect the ceramic TEG from damage. The wear plate can be for example, a silicon pad which conducts heat and is relatively conformal. Alternatively, the wear plate can be made from a thermally conductive metal.

Preferably, the entire electric generator of the present invention is lightweight and weighs less than about 50 grams or the approximate weight of two AA batteries. Still further, it is envisioned that the thermal mass weights less than about 40 grams.

In certain embodiments of the present invention, the thermal mass includes water and an additive to prevent freezing. However, it is envisioned that the thermal mass can be a substance that freezes during the thermal cycle experienced by the aircraft. For example, the thermal mass can include water and an additive to modify its liquid-solid phase change temperature, so as to ensure a phase change will occur within the thermal cycle experienced by the aircraft. Alternatively, the thermal mass is a refrigerant that vaporizes and condenses during the thermal cycle experienced by the aircraft. Moreover, in certain embodiments of the present invention, the thermal mass is a solid, such as aluminum.

It is envisioned that the electric generator can further include a large multi-Farad capacitor and the electrical energy created by the thermoelectric generator is used to charge a large multi-Farad capacitor. Moreover, the circuit can include a DC-DC converter that boosts the voltage from the thermoelectric generator.

As will be discussed in more detail herein below, in alternative embodiments of the present invention, the electric generator further includes a second thermoelectric generator connected thermally in series with the first thermoelectric generator. It is envisioned that the second thermoelectric generator can be connected electrically in series with the thermoelectric generator or the second thermoelectric generator can be connected electrically in parallel with the thermoelectric generator.

Alternatively, the electric generator can include a second thermoelectric generator which is connected thermally in parallel with thermoelectric generator. It is envisioned that the second thermoelectric generator can be connected electrically in series with the thermoelectric generator or the second thermoelectric generator can be connected electrically in parallel with the thermoelectric generator.

In certain embodiments of the present invention, the electric generator further includes a battery or other electric storage device that is charged by circuit.

Preferably, the housing is cubical and insulated on all but one side.

It is envisioned that in certain constructions, the electric generator can include a finned heat exchanger disposed within the interior chamber defined in the housing which is in thermal contact with the TEG and the thermal mass.

These and other features and benefits of the subject invention and the manner in which it is assembled and employed will become more readily apparent to those having ordinary skill in the art from the following enabling description of the preferred embodiments of the subject invention taken in conjunction with the several drawings described below.

### BRIEF DESCRIPTION OF THE DRAWINGS

So that those skilled in the art to which the subject invention appertains will readily understand how to make and use the systems and method of the subject invention without undue experimentation, preferred embodiments thereof will be described in detail hereinbelow with reference to certain figures, wherein:

Figure 1 is a perspective view of a conventional thermoelectric generator which includes a large finned heat sink;

Figure 2 is a cross-section view of a sinkless thermoelectric energy generator which has been constructed in accordance with an embodiment of the present invention;

Figure 3 is a graphical representation of the temperature variations experienced by the airframe of a Boeing 777 during a test flight;

Figure 4 is a graphical representation of the results of a flight simulation to predict the deviation between the temperature of the aircraft structure and a thermal mass that does not experience a phase change;

Figure 5 is a graphical representation of the predicted deviation between the temperature of the aircraft structure and the thermal mass that freezes during a second flight simulation;

Figure 6 is a cross-sectional view of a prototype sinkless thermoelectric generator;

Figure 7 is a schematic representation of a circuit which could be used in conjunction with the prototype of Figure 6;

Figure 8 is a graphical representation showing the temperature of the cold plate and the thermal mass over time and the energy generated by the TEG during a first prototype test (airframe structure); and

Figure 9 is a graphical representation showing the temperature of the cold plate and the thermal mass over time and the energy generated by the TEG during a second prototype test (gearbox).

These and other aspects of the subject invention will become more readily apparent to those having ordinary skill in the art from the following detailed description of the invention taken in conjunction with the drawings.

### DETAILED DESCRIPTION OF PREFERRED EMBODIMENTS

Disclosed herein are detailed descriptions of specific embodiments of the sinkless thermoelectric energy generating devices and methods of the present invention. It will be understood that the disclosed embodiments are merely examples of ways in which certain aspects of the invention can be implemented and do not represent an exhaustive list of all of the ways the invention may be embodied. Indeed, it will be understood that the systems, devices, and methods described herein may be embodied in various and alternative forms. The figures are not necessarily to scale and some features may be exaggerated or minimized to show details of particular components. Well-known components, materials or methods are not necessarily described in great detail in order to avoid obscuring the present disclosure.

Figures illustrating the components show some elements that are known and will be recognized by one skilled in the art. The detailed descriptions of such elements are not necessary to an understanding of the invention, and accordingly, are herein presented only to the degree necessary to facilitate an understanding of the novel features of the present invention.

As discussed herein below, the present invention relates to a thermoelectric energy harvester that does not require a heat sink, only a thermal source that varies in temperature over time. The thermal energy harvester or energy harvesting device uses a small, insulated thermal mass (preferably less than but not limited to 50 grams) that is either heated or cooled by thermal energy that passes through a thermoelectric generator (TEG). The varying thermal source could be the skin (or airframe attached to the skin) of an aircraft that climbs or descends. It could also be a structural member close to an engine or gearbox that heats up and cools down during operation of the aircraft.

The energy harvesting devices of the present invention, when made the approximate size and weight of two AA lithium batteries, can generate enough energy from a single flight, for example, to power devices such as a low-powered wireless sensor for one day. Moreover, since the thermal energy harvester is insulated, it is completely self-contained except for the need to expose one surface to a structure that changes temperature. That, in combination with its small size, makes mounting the thermal energy harvester of the present invention easier and more practical than a traditional thermal harvester.

An advantage of the thermal harvester disclosed herein over existing devices is that it only requires one thermal connection or contact surface, not two. Other advantages are that it is comparatively small, it does not require air flow, and since it is sealed it is not affected by dirt or other contaminants. Also, it consists of components that are known to be robust with long, indefinite life-times and no moving parts; which is ideal for permanent installations, especially in locations which are not easily accessible.

Referring now to the drawings wherein similar reference numerals identify similar structural features or aspects of the subject invention, there is illustrated in Fig. 2, a sinkless thermoelectric energy generator 10 for generating electrical power from temperature cycles encountered by the structure of an aircraft. Sinkless energy generator 10 includes a thermoelectric generator (TEG) 20 and an insulated housing 30 which contains a thermal mass 40. The thermoelectric generator 20 is in thermal contact with the structure "S" of an aircraft. In the embodiment shown herein, the insulated housing 30 is cubic and has a height of 4 centimeters, a length of 3 centimeters and a width of 3 centimeters.

As noted above, the insulated housing 30 and the thermal mass 40 are positioned in thermal contact with the thermoelectric generator 20. As a result, during the temperature cycles encountered by the structure of the aircraft, energy is created by the thermoelectric generator 20 when heat is released from the thermal mass 40 contained within the housing 30 through the thermoelectric generator 20 to the aircraft's structure "S" and when heat is supplied from the aircraft's structure "S" through the thermoelectric generator 20 to the thermal mass 40.

As will be discussed below, a circuit (not shown) provides the energy generated by the thermoelectric generator 20 during the temperature cycles encountered by the structure of the aircraft to a device, such as a wireless sensor.

In the embodiment shown in Figure 2, the thermoelectric generator is in thermal contact with the skin of the aircraft and the skin of the aircraft encounters temperature cycles during ascent and descent. Additionally, the thermal mass is composed of 50 percent water and 50 percent propylene glycol and has a specific heat of about 3.33J/g°K. However, as noted previously, a variety of thermal masses can be used without departing from the inventive aspects of the present invention.

A wear plate 22 is positioned between the thermoelectric generator 20 and the structure of the aircraft "S". The wear plate 22 protects the ceramic TEG 20 from damage. The wear plate 22 is a silicon pad which conducts heat and is relatively conformal.

When constructed as shown in Figure 2, sinkless thermoelectric energy generator 10 of the present invention is lightweight and weighs less than about 50 grams or the approximate weight of two AA batteries. Still further, it is envisioned that the thermal mass weighs less than about 40 grams.

Although it is not shown in Figure 2, sinkless thermoelectric energy generator 10 can further include a large multi-Farad capacitor and the electrical energy created by the thermoelectric generator 20 is used to charge the large multi-Farad capacitor. Moreover, a DC-DC converter can be used to boost the voltage from the thermoelectric generator.

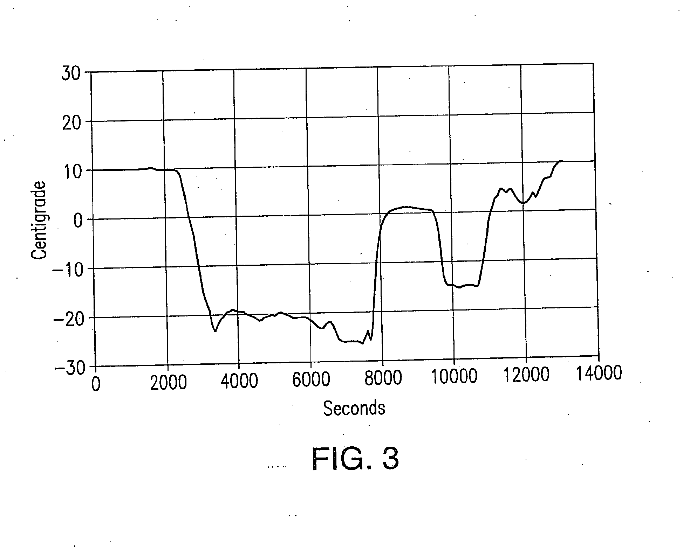

In April 2007, The Boeing Company conducted a study to determine the temperature variations experienced by the airframe of a Boeing 777 aircraft during the length of a test flight. Of particular interest was the temperature of the inboard surface of a stringer located slightly above a passenger window and just forward of the wing. Figure 3 is a graphical representation which shows the temperature profile of the stringer during the test flight in which the aircraft was first on the ground, then ascended to a 43,000-foot cruise altitude, then descended to a 20,000-foot cruise altitude, then ascended again to 30,000 feet, and then descended to 10,000 feet before landing.

For aircraft applications, it was considered desirable to have the size of the thermal mass to be the equivalent of two AA batteries (i.e., the two batteries to be replaced in a wireless sensor), which represents about 50 cc of volume. A search of materials to act as the thermal mass showed that the specific heat of water was much greater than all other common, easy to work with materials, even metal. For example, the specific heat of aluminum, one of the preferred metals, is only 0.897 J/g°K (Joules per gram, degree Kelvin), whereas water is 4.18 J/g°K. Although, ammonia is somewhat better that water and has a specific heat of 4.700 J/g°K, it boils at -33°C making it difficult to work with. However, ammonia may be a useful additive to water in some applications.

In terms of volume instead of mass, water is still preferred, but aluminum compared much better. The volumetric heat capacities are 4.18 J/cc°K and 2.42 J/cc°K, respectively.

Utilizing a liquid thermal mass instead of a solid has some drawbacks, but there are some advantages too. For a liquid, such as water, a sealed container or housing is needed. Moreover, temperatures cannot exceed much beyond 100°C without generating high steam pressure. Additionally, the housing or container for the thermal mass must be able to withstand the expansion of ice when the water freezes. For aircraft skin applications, water will not boil, but it will freeze. One solution is to use a 50:50 mixture of propylene glycol and water giving a specific heat of 3.33 J/g°K.

Another solution when encountering temperatures below freezing is to leave room for expansion in the container and allow the water to freeze. The advantage to this method is that water has a latent heat of melting (or freezing) of 334 J/g. This greatly magnifies the amount of energy stored in the thermal mass, equivalent to an 80-degree change in temperature.

Using the ascent portion of the temperature plot from the data provided in Figure 3, the temperature changes from +10°C to -20°C passing through the freezing point of water. Thirty-six (36) grams (leaving room for expansion) of water gives up 1500 Joules of heat as a liquid, 12,000 Joules while freezing, and another 1500 Joules as ice (the specific heat of ice is 2.108 J/g°K). That is, the water gives up a total of 15,000 Joules of heat during the ascent. If all of this heat passes through the TEG and the TEG is 5% efficient, it will produce 750 Joules of electrical power. A similar amount of power is produced during descent. For comparison purposes, a small, thin-film lithium rechargeable battery holds 14.4J, a 10F super capacitor holds 31J, a AA, non-rechargeable lithium battery holds 31,000J, and 500 microJoules is required for a single sample to be measured and transmitted from a wireless sensor.

The present invention can also be mounted on a helicopter gearbox where the temperature ranges from ambient 20°C to 75°C during operation. Using 50cc (135 grams) of aluminum as the thermal mass gives 6660 Joules of heat or 333 Joules of electricity. As a result, a metal, such as aluminum, is preferred for high-temperature areas like engines and gearboxes (which do not transition through 0°C) and a water-based thermal mass is preferred for ambient to low temperature applications.

A number of computer simulations were performed to determine the best configuration to use for a first prototype. A typical simulation started with the temperature profile from the Boeing test shown in Figure 3. A TEG was chosen that was compatible with the size of the thermal mass, a DT3-8 from Marlow. The thermal resistance (Rₜₕ) of the DT3-8 is 5 °K/Watt of heat flowing through it. The open-circuit voltage of the TEG is proportional to the temperature difference across it: 0.0162 volts per degree Kelvin. The internal electrical resistance of the TEG is 0.5 Ohms and the load that the power was being transferred to was made the same resistance to maximize the power transfer. A thermal mass with antifreeze was chosen to avoid the complication of freezing water. 36 grams of a 50:50 mixture of propylene glycol and water was simulated. It had a specific heat of 3.33 J/g*K.

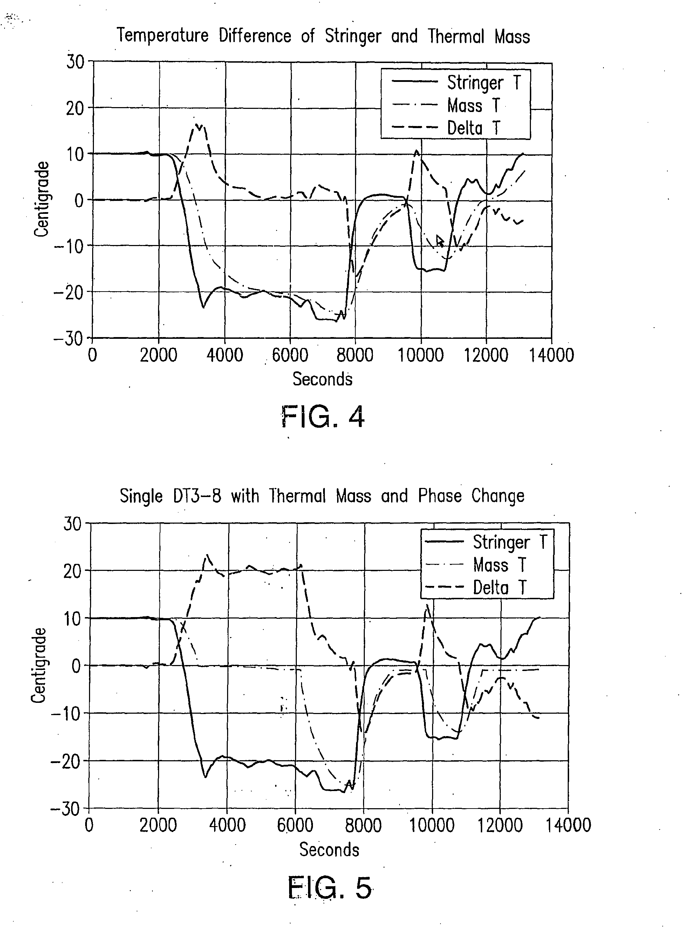

Figure 4 shows the thermal performance of this simulation. The solid line is the stringer temperature from the Boeing test sampled at one-second intervals. The "-*-*" line shows the temperature of the thermal mass. Notice that its temperature lags the stringer temperature due to the thermal resistance of the TEG. The dashed "----" line illustrates the difference in temperature between the stringer and the thermal mass which is also the temperature across the TEG. The power delivered to the load by the TEG is proportional to the square of the temperature difference. The peak power at 3000 seconds into the flight is about 70mW. The electrical energy derived from the whole flight was 127 Joules, consistent with a general estimate that the heat to electricity conversion would be about 5% efficient.

Another simulation was run that was similar to the above, but allowed the water to freeze. In this case the specific heat of water is 4.186 J/g*K, the specific heat of ice is 2.108 J/g*K, and the latent heat of melting or freezing is 334 J/g. All other parameters were the same as the previous simulation.

The results of this simulation are represented in Figure 5. Notice in the plot that the temperature of the thermal mass lags the temperature of the stringer as before, but stops at zero degrees. As the stringer continues to cool, the temperature difference grows larger than before and holds that difference for much longer. The peak power from the TEG was 145mW 3360 seconds into the flight. The total electrical energy from the flight was 433 Joules, over three times more than the first simulation. Thus, allowing water to freeze gives an obvious advantage.

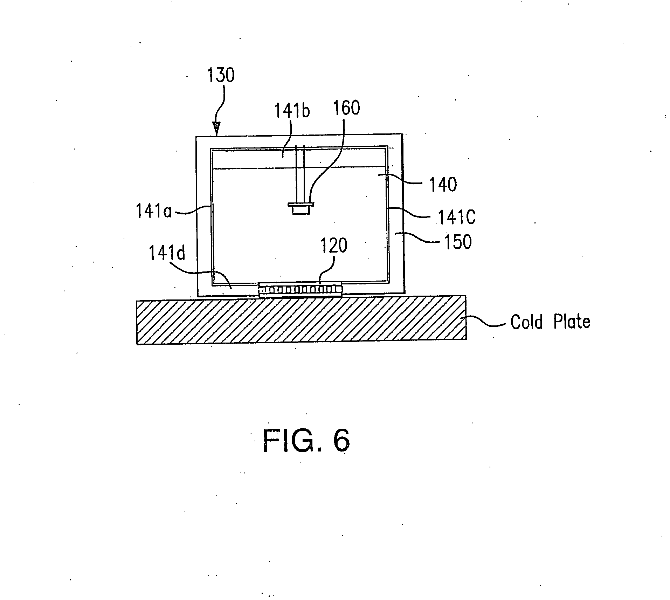

In addition to these simulations, several prototype tests were performed. The prototype used in the testing is shown in Figure 6. A housing 130 to contain the liquid thermal mass 140 was constructed using copper-clad, fiberglass printed circuit board material on five sides (141a-c, shown). A sheet of plain copper was used as the sixth side 141d to interface the TEG 120 to the thermal mass 140. All edges, except for a lid, were soldered producing a fluid-tight container. A rubber sheet 150 was then cut and glued to the fiberglass to insulate the thermal mass 140 from any heat flow other than through the TEG 120. A temperature probe 160 was mounted to the lid for monitoring the temperature of the thermal mass 140.

The TEG 120 used for this study was 20mm square and 3.6mm thick. It puts out an open circuit voltage that is proportional to the temperature difference between one side and the other, 6.5mV/°C. The internal resistance of the TEG 120 is about 0.5 Ohms. A load of the same resistance was needed for maximum power output.

A TEG is a low-impedance, low-voltage device. The simulations above produced a few tenths of a volt at most. This voltage is not only too low to power our circuits, but it is too low to be boosted with typical DC-DC converters. One approach is to connect a number of TEGs in series to obtain a higher voltage. New TEGs are becoming available that are small enough to make this practical, but they are expensive singly and prohibitive in the quantity needed for a useful voltage. However, Linear Technology manufactures the LTC3108, a DC-DC booster that can work with voltages as low as 20mV.

The LTC3108 uses a high-turns ratio transformer on the frontend that is part of an oscillator circuit. The oscillator runs in the 100 KHz range allowing the transformer to be very small physically. The transformer is followed by a charge pump and rectifier giving another boost to the voltage. The rest of the LTC3108 is designed for energy harvesting with features such as a very low quiescent current and a synchronous rectifier using FET switches to avoid the forward voltage drop of a diode. The output is regulated to one of four selectable voltages along with a "power good" signal. It also has features for working with a storage device such as a super-cap or rechargeable battery.

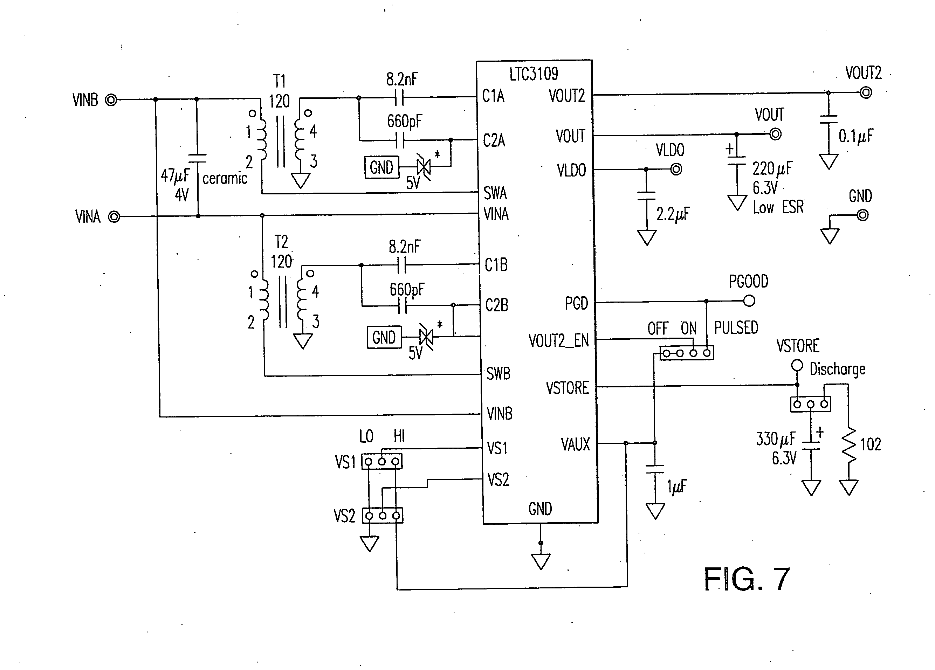

The LTC3108 was followed by the LTC3109, a bipolar version that can capture energy from a TEG with heat flowing in either direction as is the case for this invention. The LTC3109 was used in the prototype testing discussed herein and is schematically represented in Figure 7. A 1:20 transformer was used to best match the TEG voltage levels to the output which was set to 2.35V. The low output voltage was to accommodate the 2.7-volt super-caps used in some tests. Vout2 was not used.

For the prototype testing, the aircraft skin was simulated by a "cold plate". The cold plate is programmable and can ramp and soak at specified temperatures reproducing altitude changes and cruising of the aircraft.

The flight scenario that was simulated was:
1. Begin at +20C.
2. Ramp to -20C over 15 minutes (ascend).
3. Soak for 3 hours (cruise).
4. Ramp to +5C over 5 minutes (descend to approach).
5. Soak for 5 minutes (holding pattern).
6. Ramp to +20C over 5 minutes (land).
7. Soak for 30 minutes (taxi).

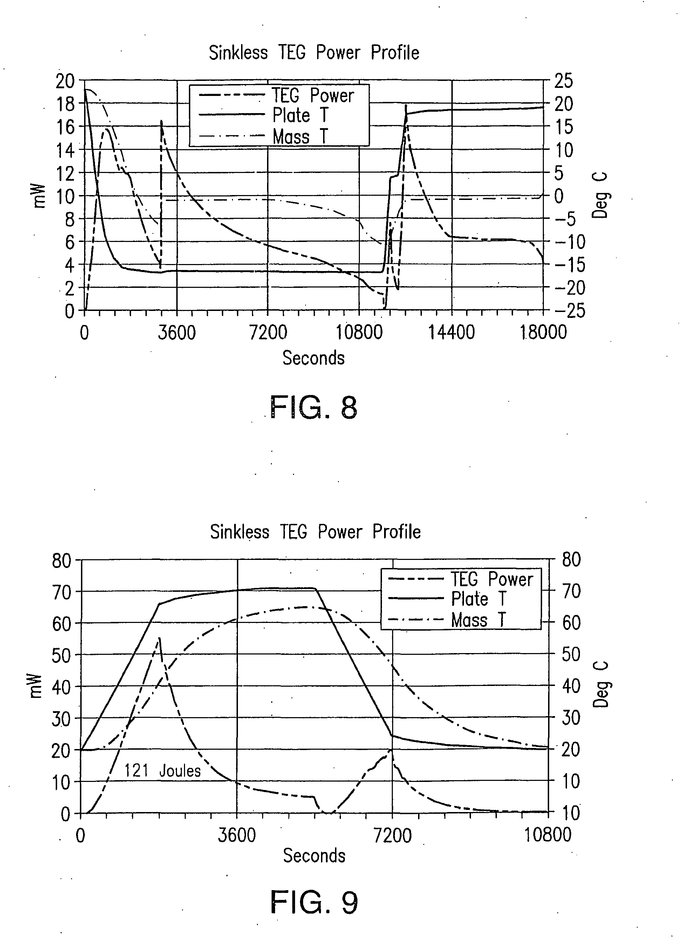

Figure 8 illustrates the results of this prototype test, wherein he flight was simulated, but the temperature and power measurements are real. The solid line shows the cold plate temperature, the simulated aircraft skin. The "-* -*" line shows the temperature of the thermal mass, distilled water.

Unlike in the computer simulation, the water super-cools before freezing. This interesting effect can be seen at about the 3000-second point in the plot. The water cools to -7C before it suddenly snaps back to 0C as ice begins to form. The temperature probe is positioned in the center of the thermal mass and it holds at a steady 0°C for about 70 minutes. At 7200 seconds, the 2-hour point, the temperature resumes decreasing at a slow rate. Here, ice, freezing from the bottom up and able to go below 0°C, has reached the temperature probe, but there is still liquid yet to freeze. At the 3-hour point, the water is completely frozen and the temperature is free to drop quickly.

The voltage from the TEG is proportional to the temperature difference across its plates and the power is proportional to the square of the voltage. We can see from the dashed curve that, even though the temperature difference stayed constant during the second hour, the power dropped. This is because ice formed near the TEG first before reaching the temperature probe. The ice acted as an insulator, increasing the thermal resistance of heat flowing from the liquid water to the TEG. Although the power is diminishing during the second hour, the freezing of the water takes longer and the total energy harvested is about the same as if the ice formed in a different place. Another way to look at it is, assuming the box is well insulated, all of the thermal energy in the water has to flow through the TEG and be harvested no matter how long it takes.

As the aircraft descends and the skin temperature rises, the ice quickly warms to 0°C where it remains until just at the end of the plot. The power, which is indicative of the temperature at the TEG, shows a somewhat different story. The power peaks quickly (at about the three and a half hour point) and drops off as the ice warms. The power drop stops when the ice begins to melt. Melting and freezing are not symmetrical. During melting, liquid water is next to the TEG and it conducts heat much better than ice. The liquid water does not rise above zero degrees and the power generated stays flat until all of the ice melts. The ice melts more quickly than it freezes but, once again, all energy is still harvested since it all passes through the TEG.

It appears that the shape of the prototype was close to ideal for a flight of several hours. Shorter flights may require moving the thermal energy through the TEG a little quicker. This can be accomplished by increasing the area of the copper plate on the side of the box that the TEG is against. This may also be a good strategy for longer flights if the power management circuit has a storage device.

The orientation of the box will affect the thermal contact of the TEG with the water/ice. Leaving room in the box for thermal expansion effectively puts a bubble of air in the box. This bubble will interfere with the flow of heat when the box is mounted vertically or upside down (TEG on the top). Although in the prototype, the interior of the box was copper to help heat to flow no matter where the water was, the testing shows that ice slows heat flow even with the copper. A layer of air next to the TEG will slow heat flow even further. A finned heat exchanger inside the box will lessen the effect of box orientation.

A second prototype test was conducted for high temperature excursions, such as gearbox applications. The temperature profile used to simulate a helicopter gearbox warming up during flight and cooling afterwards was:
1. Begin at +20C.
2. Ramp to 77C over 30 minutes.
3. Soak for 1 hour.
   Ramp to 20C over 30 minutes

Once again, the flight was simulated, but the temperature and power measurements were real. In Figure 9, the solid line shows the cold plate temperature, the simulated gearbox housing. The "-*-*" line shows the temperature of the thermal mass, distilled water.

Compared to the aircraft skin temperature, the gearbox temperature changes 57 degrees instead of 40 degrees. This produces a higher peak power output. However, the thermal mass does not go through a phase change and 121 Joules of energy is harvested, a little less than the aircraft skin simulation.

The sinkless thermoelectric generator of the present invention is ideal for applications where a heat sink is not conveniently located relative to the heat source and where the heat source varies with time.

The sinkless thermoelectric generator of the present invention can be used in conjunction with, for example, a low-power radio link coupled with any of a number of low-power sensors such as accelerometers (vibration and inertial), temperature, capacitive, proximity, and pressure. The potential also exists to control low-power actuators and indicators, such as, the dimmable windows in an aircraft cabin.

The initial size and weight of the sinkless thermoelectric generator was that of two AA batteries. With the use of water, a thermal mass of this size provides a useful amount of power. The only substance with a higher specific heat is ammonia. A larger thermal mass can be used if more energy is needed. Ensuring a phase change of the thermal mass will also increase the available energy. The temperature at which water freezes can be modified with additives, ammonia being a good choice.

To avoid the problems associated with boiling when the heat source has a high temperature, a metal thermal mass might be a better choice. Aluminum is a good choice being better than steel by weight. Iron or copper are good for minimizing volume. Also, metal has the advantage of being easier to work with than a container of liquid.

While the subject invention has been described with respect to preferred embodiments, those skilled in the art will readily appreciate that changes and modifications may be made thereto without departing from the spirit and scope of the subject invention as defined by the appended claims.

## Claims

1. An electric generator for generating electrical power from temperature cycles encountered by the structure of an aircraft, comprising:
a) a thermoelectric generator in thermal contact with the structure of the aircraft;
b) an insulated housing containing a thermal mass which is positioned in thermal contact with the thermoelectric generator; wherein during the temperature cycles encountered by the structure of the aircraft, energy is created by the thermoelectric generator when heat is released from the thermal mass through the thermoelectric generator to the aircraft's structure and when heat is supplied from the aircraft's structure through the thermoelectric generator to the thermal mass;
c) a circuit for providing the energy generated by the thermoelectric generator during the temperature cycles encountered by the structure of the aircraft to a device.

2. An electric generator as recited in claim 1, wherein at least one of a), b) and c):-
a) the thermoelectric generator is in thermal contact with the skin of the aircraft and the skin of the aircraft encounters temperature cycles during ascent and descent;
b) the thermoelectric generator is in thermal contact with the airframe of the aircraft and the airframe of the aircraft encounters temperature cycles during ascent and descent;
c) the thermoelectric generator is in thermal contact with structure of the aircraft that encounters temperature cycles during operation of the aircraft's engine.

3. An electric generator as recited in claim 1, wherein the thermal mass includes water.

4. An electric generator as recited in claim 3, wherein the thermal mass includes propylene glycol, and
optionally:-
the thermal mass is fifty percent water and fifty percent propylene glycol and has a specific heat of about 3.33J/g°K.

5. An electric generator as recited in claim 1, wherein at least one of:-
a) the energy generated by the thermoelectric generator is used to power a wireless sensor;
b) the electrical generator further comprises a wear plate positioned between the thermoelectric generator and the structure of the aircraft.

6. An electric generator as recited in claim 1, wherein at least one of:-
a) the thermal mass weights less than about 40 grams;
b) the thermal mass includes water and an additive to prevent freezing.

7. An electric generator as recited in claim 1, wherein at least one of:-
a) the electrical generator further comprises a large multi-Farad capacitor and the electrical energy created by the thermoelectric generator is used to charge a large multi-Farad capacitor;
b) the circuit includes a DC-DC converter that boosts the voltage from the thermoelectric generator.

8. An electric generator as recited in claim 1, further comprising a second thermoelectric generator connected thermally in series with thermoelectric generator.

9. An electric generator as recited in claim 8, wherein:-
a) the second thermoelectric generator is connected electrically in series with the thermoelectric generator; or
b) the second thermoelectric generator is connected electrically in parallel with the thermoelectric generator.

10. An electric generator as recited in claim 1, further comprising a second thermoelectric generator connected thermally in parallel with thermoelectric generator.

11. An electric generator as recited in claim 10, wherein:-
a) the second thermoelectric generator is connected electrically in series with the thermoelectric generator; or
b) the second thermoelectric generator is connected electrically in parallel with the thermoelectric generator.

12. An electric generator as recited in claim 1, wherein at least one of:-
a) the thermal mass is a substance that freezes during the thermal cycle experienced by the aircraft;
b) the thermal mass is a refrigerant that vaporizes and condenses during the thermal cycle experienced by the aircraft.

13. An electric generator as recited in claim 3, wherein the water includes an additive to modify its liquid-solid phase change temperature so as to occur within the thermal cycle experienced by the aircraft.

14. An electric generator as recited in claim 1, wherein the thermal mass is a solid, such as aluminum.

15. An electric generator as recited in claim 1, wherein at least one of a), b) and c):-
a) the electrical generator further comprises a battery or other electrical storage device that is charged by circuit;
b) the housing is cubical and insulated on all but one side;
c) the electrical generator further comprises a finned heat exchanger disposed within an interior chamber defined in the housing, the finned heat exchanger being in thermal contact with the TEG and the thermal mass.
